**Europäisches Patentamt**

**European Patent Office**

**Office européen des brevets**

(19)

(11) Veröffentlichungsnummer : **0 365 785 B1**

(12) **EUROPÄISCHE PATENTSCHRIFT**

(45) Veröffentlichungstag der Patentschrift :
**02.11.94 Patentblatt 94/44**

(51) Int. Cl.$^5$ : **H04J 4/00**

(21) Anmeldenummer : **89115677.0**

(22) Anmeldetag : **25.08.89**

(54) **Filterbank zum Frequenzmultiplexen bzw. Frequenzdemultiplexen von Kanalsignalen.**

(30) Priorität : **22.10.88 DE 3836081**

(43) Veröffentlichungstag der Anmeldung :
**02.05.90 Patentblatt 90/18**

(45) Bekanntmachung des Hinweises auf die
Patenterteilung :
**02.11.94 Patentblatt 94/44**

(84) Benannte Vertragsstaaten :
**BE FR GB IT NL SE**

(56) Entgegenhaltungen :
**DE-U- 8 706 928**
**US-A- 4 412 325**

(56) Entgegenhaltungen :
**FREQUENZ, Band 42, Heft 6-7, Juni/Juli 1988,
Seiten 181-189; H. GÖCKLER et al.:"Digitaler
Mehrträger-Demultiplexer für den mobilen Satellitenfunk"**
**IEEE TRANSACTIONS ON COMMUNICA-
TIONS, Band COM-30, Nr. 7, Juli 1982, Seiten
1623-1628; E. DEL RE et al.: "An analytic
signal approach for transmultiplexers: theory
and design"**

(73) Patentinhaber : **ANT Nachrichtentechnik
GmbH
Gerberstrasse 33
D-71522 Backnang (DE)**

(72) Erfinder : **Göckler, Heinz, Dipl.-Ing.
Elbinger Strasse 52
D-7150 Backnang (DE)**

EP 0 365 785 B1

## Beschreibung

Die Erfindung bezieht sich auf eine Filterbank gemäß Oberbegriff der Patentansprüche 1 oder 2.

Filterbänke sind bekannt, beispielsweise durch den Aufsatz von Del Re und Emiliani "An Analytical Signal Approach for Transmultiplexers: Theory and Design" in IEEE Transactions on Communications, Vol. Com-30, No.7, Juli 1982, Seiten 1623 ff.

Derartige Filterbänke werden hauptsächlich zum Multiplexen oder Demultiplexen von FDM-Einzelkanälen in sogenannten Transmultiplexern eingesetzt, welche der Umsetzung von FDM in TDM bzw. umgekehrt dienen und beispielsweise in der Satellitentechnik oder im Telefonnetz Anwendung finden. Gerade in der Satellitentechnik ist es oberstes Gebot, dafür zu sorgen, daß die Nutzlast so gering wie möglich ausfällt.

In DE-U-8 706 928 wurde vorgeschlagen, die L-Kanalfilter durch eine Kaskadierung von mehreren Filtern mit jeweils komplexwertigen Koeffizienten zu realisieren, wobei jeweils in jeder folgenden Kaskadenstufe die Abtastrate um einen Faktor > 1 reduziert bzw. erhöht ist.

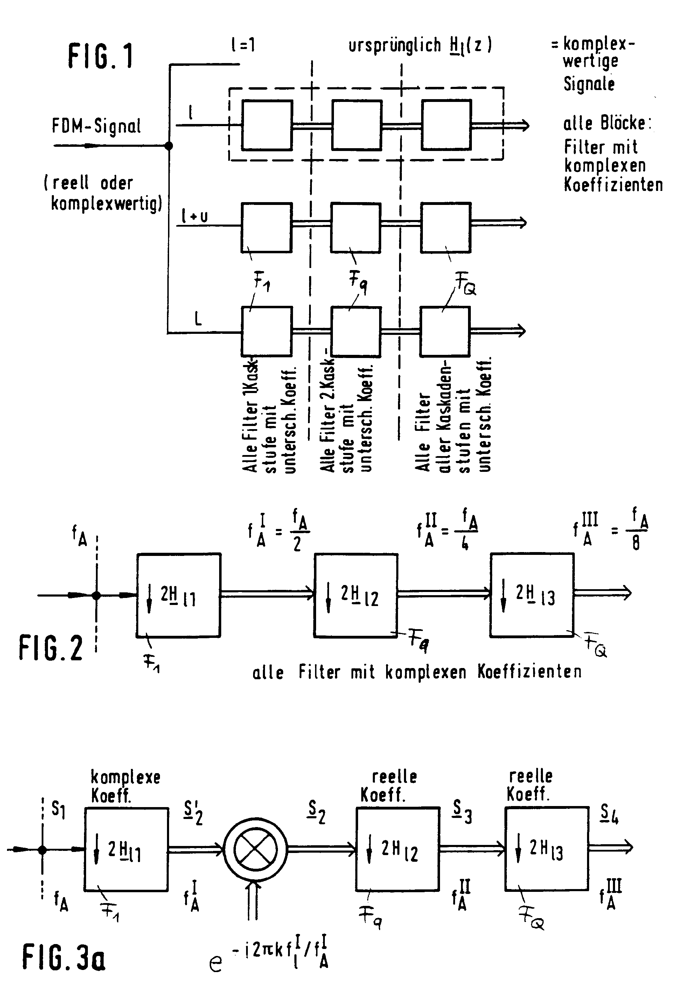

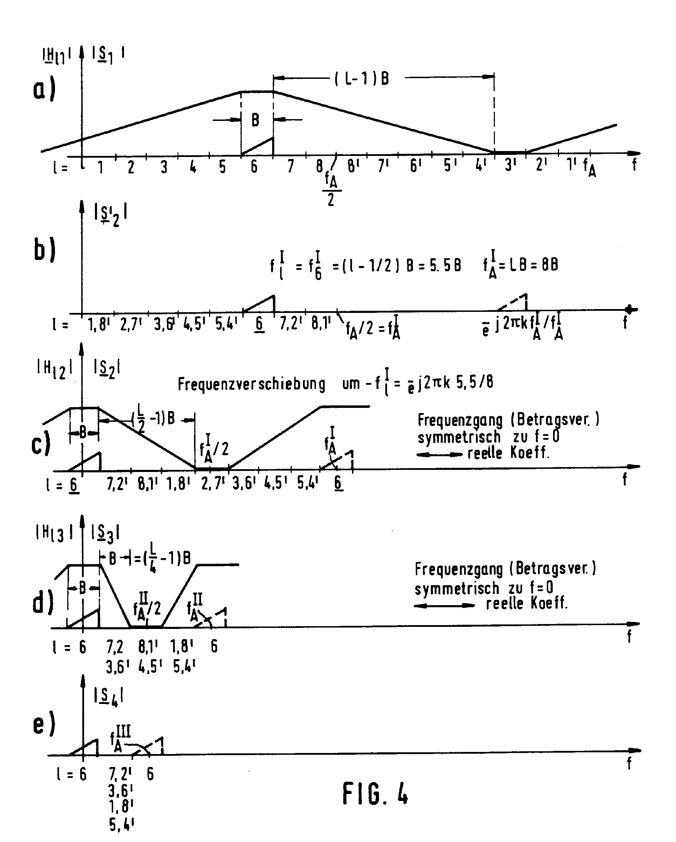

Charakteristisch hierbei ist, daß im allgemeinen alle Filter der einzelnen Transmultiplexerzweige, aber auch die mit der gleichen Abtastfrequenz arbeitenden Filter der einzelnen Kaskadenstufen jeweils unterschiedliche Koeffizienten aufweisen, siehe Figur 1.

Dadurch, daß sich im allgemeinen sämtliche Koeffizientensätze unterscheiden, entstehen Nachteile bei der überschaubarkeit, beim Entwurf, beim Test, bei der Fertigung und bei der Ausführung von redundanten Baugruppen, beispielsweise in Satellitenanwendungen. Darüberhinaus weisen alle Filter grundsätzlich komplexwertige Koeffizienten auf.

Der vorliegenden Erfindung lag deshalb die Aufgabe zugrunde, eine Filterbank der eingangs genannten Art anzugeben, bei der der Schaltungsaufwand noch weiter vermindert ist bzw. bei der noch weiter verbesserte Systemeigenschaften bei unverändertem Schaltungsaufwand zu erzielen sind.

Diese Aufgabe wurde gelöst mit den kennzeichnenden Merkmalen des Patentanspruches 1 bzw. 2.

Die erfindungsgemäße Filterbank weist den Vorteil eines kleineren Schaltungsaufwandes auf bzw. den Vorteil besserer Systemeigenschaften bei gleichem Schaltungsaufwand. Vorteilhafte Ausgestaltungen der Erfindung ergeben sich durch die Unteransprüche.

Insbesondere wirkt sich der Vorteil der vorliegenden Filterbank dadurch aus, daß die Zahl der Filter mit unterschiedlichen Koeffizienten stark vermindert ist. In optimalen Ausführungsfällen ist dies so ausgebildet, daß zwar alle kaskadierten Filter eines Einwegtransmultiplexerkanals, also eines Zweiges, zwar unterschiedliche Koeffizienten aufweisen, daß aber in den einzelnen Kaskadenstufen für alle Kanäle jeweils ein identisches Filter mit identischen Koeffizienten verwendet werden kann. Weiterhin sind die Koeffizienten dieser Filter reellwertig, wodurch sich die Anzahl der Rechenoperationen stark verringert.

Bei einem anderen Ausführungsbeispiel läßt sich der Rechenaufwand dadurch vermindern, daß die aufwendigeren Filter der letzteren Kaskadenstufen innerhalb einer Kaskadenstufe für alle Kanäle gleich gemacht werden.

Es erfolgt nun die Beschreibung anhand der Figuren.

| | |
|---|---|
| Die Figuren 1 und 2 | zeigen das Blockschaltbild des eines FDM-Demultiplexers gemäß der Lösung nach der Hauptanmeldung. |
| Die Figuren 3a und 3b | zeigen jeweils ein Ausführungsbeispiel gemäß der vorliegenden Erfindung. |
| In Figur 4 | sind einige spektrale Kurven dargestellt. |
| In den Figuren 5 und 6 | sind detaillierte Blockschaltbilder für den verwendeten Multiplizierer für komplexwertige Faktoren und für ein Halbbandfilter mit reellen Koeffizientenden ausgeführt. |
| Die Figur 7 | zeigt ein detailliertes Schaltbild eines Zweiges eines Halbbandfilters. |
| In Figur 8 | schließlich ist eine Filterkaskade gezeichnet als Beispiel, anhand dessen der verminderte Schalt- bzw. Multiplikatoins- und Additionsaufwand berechnet wird. |

Es folgt nun die ausführliche Beschreibung der Figuren.

In der Figur 1 ist ein FDM-Demultiplexer für l=1 bis L Einzelkanalsignale gezeichnet. Er enthält also L-Zweige mit mehreren kaskadierten Filtern, welche komplexwertige Koeffizienten aufweisen und jeweils komplexwertige Ausgangssignale abgeben. Das FDM-Eingangssignal kann dabei reell oder komplexwertig sein. Im allgemeinen sind die Koeffizienten der einzelnen Filter über den Kanal gesehen oder über die Kaskadenstufe gesehen unterschiedlich.

Die Figur 2 zeigt mehr Details für einen einzelnen Kaskadenzweig des Demultiplexers nach Figur 1, ebenfalls nach dem Stande der Hauptanmeldung. Die Übertragungsfunktion der einzelnen Filter sei $\underline{H}_{l1}$ $\underline{H}_{l2}$ usw. In jeder Kaskadenstufe wird die Abtastrate, eingangsseitig $f_A$, um den Faktor 2 reduziert.

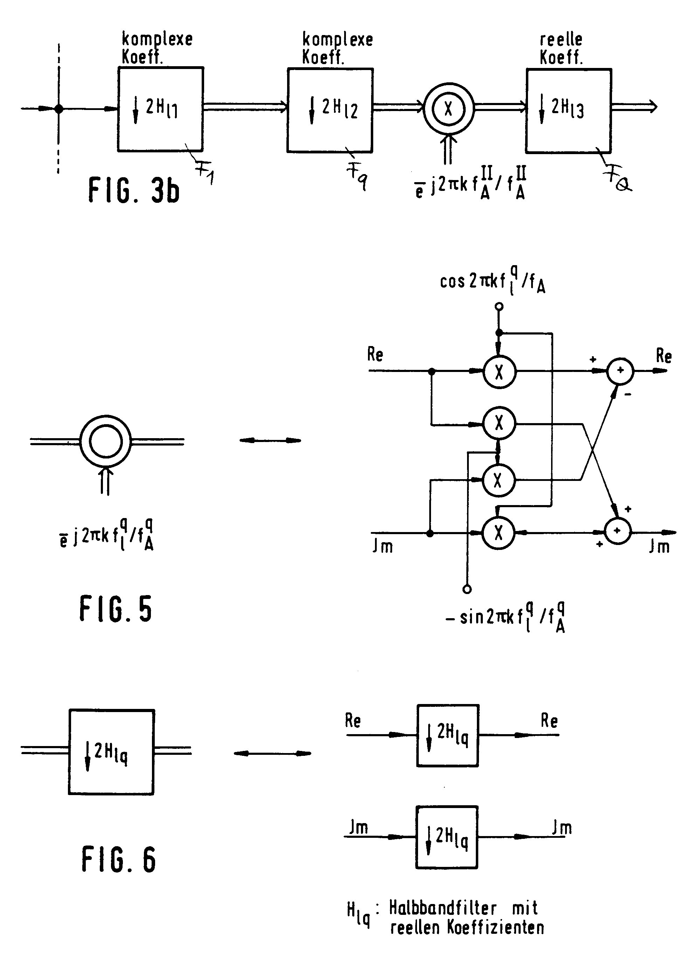

Die Figuren 3a und 3b zeigen die erfindungsgemäße Ausführung einer Filterbank. Gemäß Figur 3a ist nach

2

dem ersten Filter mit der Übertragungsfunktion $H_{I1}$ ein Multiplizierer eingefügt, der die komplexwertigen Ausgangssignale $S_2$ mit den Abtastwerten einer komplexen Trägerschwingung $_e$-j2 $\pi$ k . $f_I^I$ / $f_A^I$ multipliziert.

Dabei ist k die diskrete Zeitvariable, $f_I^I$ die Kanalbandmittenfrequenz im Bereich der ersten Kaskadenstufe I und $f_A^I$ die Abtastrate an der betreffenden gleichen Stelle. Das komplexe Ausgangssignal $S_2$ wird nun dem nächsten Filter der folgenden Kaskadenstufe zugeführt, wobei die Übertragungsfunktion $H_{I2}$ ist.

Die spektrale Darstellung zu Figur 3a ist zu den Diagrammen der Figuren 4a bis 4e zu entnehmen, wobei die Darstellung für den sechsten Kanal von L=8 Kanälen und entsprechend der drei Kaskadenstufen mit jeweils einer Abtastratenverminderung von zwei, also insgesamt M=8, erfolgt. Die Figur 4a zeigt die Übertragungsfunktion $|H_{I1}|$ der ersten Kaskadenstufe aufgetragen über der Frequenz f mit dem Durchlaßbereich der Breite B für den Kanal I=6, mit der Mittenfrequenz $f_{I1}$ = (I-1/2) B dieses Durchlaßbereiches und mit dem sehr weiten Übergangsbereich von jeweils B · (L-1) = 7 B symmetrisch zur Mittenfrequenz. Die Abtastfrequenz liegt bei 2 L · B=16 B. Im Übertragungsbereich ist weiterhin aufgetragen der Betrag des Spektrums des reellen Eingangssignals $|S_1|$.

In Figur 4b ist der Betrag des Ausgangssignals $|S_2|$ des ersten Filters über der Frequenz aufgetragen, sowie die Mittenfrequenz $f_I^I$ = 5,5 B. Aufgrund der Abtastraten-Reduzierung in der ersten Kaskadenstufe um den Faktor 2 fallen die Signalspektren der Kanäle 1 und 8′, 2 und 7′, 3 und 6′, 4 und 5′, 5 und 4′, 7 und 2′, 8 und 1′ jeweils aufeinander.

Durch die Multiplizierung mit den Abtastwerten des komplexen Träger

$$_e - j2 \pi k . f_I^I / f_A^I$$

erfolgt eine Frequenzverschiebung um den Wert - $f_I^I$ = 5,5 B. Dies ist in Figur 4c gezeichnet. Aufgetragen über der Frequenz ist dort ebenfalls die Übertragungsfunktion des Filters der nachfolgenden zweiten Kaskadenstufe. Man sieht, daß der Übertragungsbereich nunmehr symmetrisch zur Frequenz f=0 bzw. zur Abtastfrequenz $f_A^I$ liegt und daß die Spektren der Kanäle 2 und 7′ genau auf den Sperrbereich dieses zweiten Filters fallen, während das Spektrum des Kanals 6 exakt in den Durchlaßbereich fällt. Der zur Frequenz f=0 symmetrische Frequenzgang der nachfolgenden Filter nach der Frequenzverschiebung deutet auch darauf hin, daß diese Filter reellwertige Koeffizienten aufweisen.

Augrund der weiteren Abtastratenreduzierung um den Faktor 2 fallen die Frequenzbereiche der Kanäle 1, 8′, 5 und 4′ aufeinander und zwar auf den Sperrbereich des dritten Kaskadenfilters, wie in Figur 4d zu erkennen ist. Dort ist die Übertragungsfunktion /$H_{I3}$/ der dritten Kaskadenstufe aufgetragen. Die Übergangsbereiche weisen nun ebenfalls die Breite B auf, in sie fallen die Frequenzbereiche der Kanäle 7, 2′, 3, 6′, bzw. 1, 8′, 5,4 . In Figur 4e ist nun das Ausgangsspektrum gezeichnet, welches durch die weitere Halbierung der Abtastrate in der letzten und dritten Stufe entsteht, wobei in die Lücke zwischen dem Spektrum um die Frequenz f=0 und um die Abtastfrequenz $f_A^{III}$ dieser dritten Stufe die Rest-Spektren der verbliebenen Kanäle 1, 8′, 5, 4′, 3, 6′, 7 u. 2′ zu liegen kommen.

Wie hier am Beispiel der Demultiplexbildung für den sechsten Kanal gezeigt, kann in entsprechender Weise die Demultiplexbildung für die anderen Kanäle erfolgen.

Die Figur 5 zeigt auf der linken Seite den erfindungsgemäß eingesetzten Multiplizierer in symbolischer Weise und rechts eine detailliertere Schaltung für das linke Symbol. Man sieht dort 4 Einzelmultiplizierer, die paarweise mit dem Kosinus bzw. mit -Sinus 2 $\pi$ k · $f_I^{II}$ / $f_A^{II}$ den Realteil Re bzw. Imaginärteil Im des komplexen Eingangssignals paarweise miteinander multiplizieren; die Einzelprodukte werden über Kreuz paarweise addiert bzw. subtrahiert und ergeben Realteil und Imaginärteil des nunmehr frequenzverschobenen Signals.

In Figur 6 ist die Kurzform eines Filters, wie sie als Symbol in den Figuren 3a bzw. 3b an den dem Multiplizierer nachfolgenden Kaskadenstufen eingesetzt ist, auf der rechten Seite näher erklärt, wobei deutlich zum Ausdruck kommt, daß es sich hier um Halbbandfilter mit reellen Koeffizienten handelt, bei denen die Verarbeitung des Realteils bzw. des Imaginärteils jeweils unabhängig voneinander erfolgt.

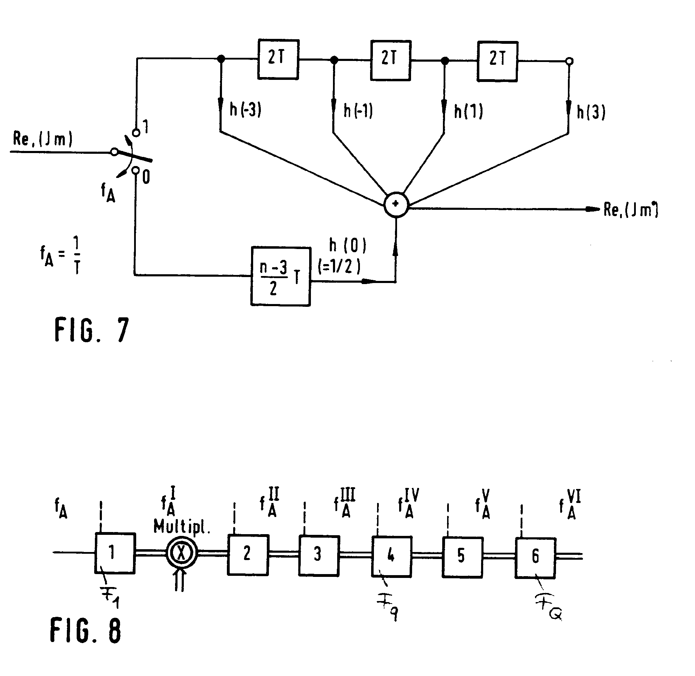

Die Figur 7 zeigt ein Beispiel für ein bekanntes Halbbandfilter mit reellen Koeffizienten der Länge n=7 zur Halbierung der Abtastfrequenz, wobei die Koeffizientensymmetrie allerdings nicht ausgenutzt ist. Bei Ausnutzung dieser Koeffizientensymmetrie h (k)= h (-k) ergeben sich für die Multiplikation eine Rate von (n+1) : 4+1=(n+5) : 4 und für die Addition (n+1) : 2.

Im folgenden sei an einer Kaskade von 6 Stufen mit jeweiliger Abtastratenhalbierung, also mit M=$2^6$ = 64 verdeutlicht, wieviel an Multiplikationsraten bzw. Additionsraten bei der erfindungsgemäßen Anordnung eingespart werden kann.

Bei dem FDM-Demultiplexer mit 6 Stufen gemäß Hauptanmeldung mit jeweils verschiedenen Filterkoeffizienten ist eine Multiplikationsrate $M_I$=314 · $f_A^{VI}$ und eine mit einer Additionsrate von $A_I$ = 408 · $f_A^{VI}$ zu rechnen, wobei jeweils die Koeffizientensymmetrie ausgenutzt wurde.

Für eine Ausführung gemäß vorliegender Erfindung, wie sie in Figur 8 dargestellt wird, mit gleichen Filterlängen wie beim vorhergehenden Beispiel, errechnen sich folgende Raten:

$$M_q = 2 \qquad \text{Filterlänge} \quad \text{Multipl.} \quad f_A^{VI} \quad \text{Add.}$$

$$\text{Stufe I} \qquad n_q = 3 \qquad (n_I+3)/2 \qquad 32 \qquad n_I$$

$$\text{Stufe II,III} \qquad n_q = 3 \qquad \left.\begin{array}{c} \dfrac{n_q+5}{4} \end{array}\right\} \qquad 16;8$$

$$\text{Stufe IV,V} \qquad n_q = 7 \qquad\qquad 4;2 \qquad \dfrac{n_q+1}{2}$$

$$\text{Stufe VI} \qquad n_q = 11 \qquad\qquad 1$$

$$\text{Multiplikation} \qquad\qquad 4 \qquad\qquad 2$$

Multiplikationsrate

$$M_{II,1} = \frac{n_I + 3}{2} \; f_A^I \; + \; 4 \, f_A^I \; + \; 2 \sum_{q = II}^{VI} \frac{n_q + 5}{4} \cdot f_A^q$$

$$= \left[ (3 + 4)32 + 4\,(16 + 8) + 6\,(4 + 2) + 8 \right] f_A^{VI}$$

$$M_{II,1} = 364 \cdot f_A^{VI} > M_I = 314 \cdot f_A^{VI}$$

Additionsrate

$$A_{II,1} = n_I \cdot f_A^I \; + \; 2 \, f_A^I \; + \; 2 \sum_{q=II}^{VI} \frac{n_q + 1}{2} \cdot f_A^q$$

$$= \left[ (3 + 2)32 + 4\,(16 + 8) + 8\,(4 + 2) + 12 \right] f_A^{VI}$$

$$A_{II,1} = 316 \cdot f_A^{VI} < A_I = 408 \, f_A^{VI}.$$

Die Multiplikationsrate beträgt also in diesem Fall 364 und ist absolut um 50 größer als bei dem Aufwand gemäß Hauptanmeldung, während die Additionsrate mit 316 um -92 deutlich unter der Additionsrate von 408 bei der Ausführung gemäß Hauptanmeldung bleibt. Da der Aufwand für Multiplikationen und Additionen sich immer mehr nähern, ist damit der Aufwand im wesentlichen gleich geblieben. Von großem Vorteil ist aber, daß 5 von 6 Filtern der Kaskade für alle Kanäle innerhalb einer gleichen Kaskadenstufe identisch geworden sind.

Wenn man den Multiplizierer nicht wie nach Figur 8 nicht nach dem ersten Filter sondern erst nach der dritten Kaskadenstufe anordnet, so ändern sich die Raten wie folgt. Die Multiplikationsrate ändert sich um minus 96 auf 268 und die Additionsrate um minus 48 auf 268 gegenüber dem Fall nach Figur 8. Damit erreicht man den Vorteil, daß 3 von 6 Filtern der Kaskade und zwar die aufwendigsten für alle Kanäle innerhalb einer Kaskadenstufe identisch geworden sind und daß der Aufwand insgesamt geringer ist verglichen mit dem Fall gemäß Figur 8 und auch mit der Vergleichsanordnung gemäß Hauptanmeldung.

Die aufgezeigten Ausführungsbeispiele beziehen sich jeweils auf einen FDM-Demultiplexer; entsprechend des Anspruches 2 und in Verknüpfung mit seinen Unteransprüchen kann die erfindungsgemäße Lehre auch auf einen Multiplexer angewendet werden, welcher aus dem Demultiplexer beispielsweise der Figuren 3a oder 3b in einfacher Weise durch inverse (transponierte) Funktion, d.h. durch eine Betriebsweise in Rückrichtung erhalten wird.

## Patentansprüche

1. Filterbank zum Frequenzdemultiplexen von L Kanalsignalen, für L > 0 und L eine natürliche Zahl, bestehend aus L Transversalfiltern (nichtrekursive Filter, Filter mit endlich langer Dauer der Impulsantwort (FIR)), mit komplexwertigen Koeffizienten, für reellwertige Eingangssignale und mit komplexwertigen Ausgangssignalen, mit am Ausgang um den Faktor M reduzierter Abtastrate, wobei mindestens eines der L Filter durch eine Kaskadierung von mindestens 2 Filtern mit jeweils komplexwertigen Koeffizienten realisiert ist, wobei bei jedem Filter ($F_1$, ... $F_q$, ... $F_Q$) innerhalb dieser Kaskade die Abtastrate um den Faktor $M_q > 1$ reduziert ist, mit

$$\prod_{q=1}^{Q} M_q = M,$$

wobei die Eingangsfilter ($F_1$) der Kaskade jeweils reellwertige Eingangssignal aufnehmen und ein komplexwertiges Ausgangssignal abgeben und wobei die anderen Filter der Kaskade jeweils ein komplexwertiges Eingangssignal aufnehmen und ein komplexwertiges Ausgangssignal abgeben, dadurch gekennzeichnet, daß jeweils in den einzelnen Filterkaskaden vor der gleichen Kaskadenstufe ein komplexer Multiplizierer eingefügt ist, mittels dem das komplexwertige Ausgangssignal des Filters der vorhergehenden Kaskadenstufe (q-1) bzw. das Eingangssignal mit der komplexen Folge einer derart abgetasteten, komplexen Trägerschwingung multipliziert wird, so daß die Filter der folgenden Kaskadenstufe (q) jeweils aus zwei separaten, identischen Tiefpaßfiltern mit reellen Koeffizienten bestehen.

2. Filterbank zum Frequenzmultiplexen von L Kanalsignalen, für L > 0 und L eine natürliche Zahl, bestehend aus L Transversalfiltern (nichtrekursive Filter, Filter mit endlich langer Dauer der Impulsantwort (FIR)), mit komplexwertigen Koeffizienten, für komplexwertige Eingangssignale und reellwertige Ausgangssignale, mit am Ausgang um den Faktor M erhöhter Abtastrate, wobei mindestens eines der L Filter durch eine Kaskadierung von mindestens 2 Filtern mit jeweils komplexwertigen Koeffizienten realisiert ist, wobei bei jedem Filter ($F_1$ ... $F_q$, ... $F_Q$) innerhalb dieser Kaskade die Abtastrate um den Faktor $M_q > 1$ erhöht ist, mit

$$\prod_{q=1}^{Q} M_q = M,$$

wobei die Q-1 ersten Filter ($F_1$, ... $F_q$, ...$F_Q$) der Kaskade jeweils ein komplexwertiges Eingangssignal aufnehmen und ein komplexwertiges Ausgangssignal abgeben und wobei die Ausgangsfilter der Kaskade jeweils ein komplexwertiges Eingangssignal aufnehmen und ein reellwertiges Ausgangssignal abgeben, dadurch gekennzeichnet, daß jeweils in den einzelnen Filterkaskaden nach der gleichen Kaskadenstufe ein komplexer Multiplizierer eingefügt ist, durch den das komplexwertige Ausgangssignal des Filters der vorangehenden Kaskadenstufe bzw. das Eingangssignal mit der komplexen Folge einer derart abgetasteten, komplexen Trägerschwingung multipliziert wird, daß die Filter der vorangehenden Kaskadenstufen jeweils aus zwei separaten, identischen Tiefpaßfiltern mit reellen Koeffizienten bestehen.

3. Filterbank nach Anspruch 1 oder 2, dadurch gekennzeichnet, daß der Faktor M in 2 Faktoren zerlegt wird mit einer Zweier-Potenz $2^i$ als erstem Faktor und einem zweiten Faktor, der gleich $M/2^i$ ist, mit i gleich einer natürlichen Zahl.

4. Filterbank nach Anspruch 3, dadurch gekennzeichnet, daß der Zweier-Potenzfaktor $2^i$ durch eine Kaskade von i Filtern mit jeweils $M_q = 2$ realisiert ist.

5. Filterbank nach Anspruch 4, dadurch gekennzeichnet, daß das Tiefpaßfilter ein Halbbandfilter ist.

6. Filterbank nach einem der vorhergehenden Ansprüche, dadurch gekennzeichnet, daß die komplexe Trägerschwingung der Funktion $e^{-j2\pi k f_1^q / f_A^q}$ genügt, wobei k die Nummer der Abtastprobe, $f_1^q$ die Kanal-Bandmittenfrequenz in der q Kaskadenstufe und $f_A^q$ die Abtastfrequenz in der q Kaskadenstufe bedeuten.

## Claims

1. Filter bank, for the frequency division demultiplexing of L channel signals for L > 0 and L a natural number, consisting of L transverse filters (non-recursive filters, filters with finitely long duration of the pulse response (FIR)), with complex value co-efficients, for real value input signals and with complex value output signals, with a scanning rate reduced by the factor M at the output, wherein at least one of the L filters is realised by a cascading of at least two filters each with respective complex value co-efficients, wherein the scanning rate is reduced by the factor $M_q > 1$ for each filter ($F_1 ... F_q ... F_Q$) within this cascade, wherein

$$\prod_{q=1}^{Q} M_q = M,$$

wherein the input filters ($F_1$) of the cascade each receive a real value input signal and deliver a complex value output signal and wherein the other filters of the cascade each receive a complex value input signal and deliver a complex value output signal, characterised thereby, that a complex multiplier, by means of which either the complex value output signal of the filter of the preceding cascade stage (q-1) or the input signal is multiplied by the complex sequence of a complex carrier oscillation scanned in such a manner, is inserted before the same cascade stage in each of the individual filter cascades so that the filters of the following cascade stages (q) each consist of two separate identical low-pass filters with real co-efficients.

2. Filter bank, for the frequency division multiplexing of L channel signals for L > 0 and L a natural number, consisting of L transverse filters (non-recursive filters, filters with finitely long duration of the pulse response (FIR)), with complex value co-efficients, for complex value input signals and real value output signals, with a scanning rate increased by the factor M at the output, wherein at least one of the L filters is realised by a cascading of at least two filters each with respective complex value co-efficients, wherein the scanning rate increased by the factor $M_q > 1$ for each filter ($F_1 ... F_q ... F_Q$) within this cascade, wherein

$$\prod_{q=1}^{Q} M_q = M,$$

wherein the Q - 1 first filters ($F_1 ... F_q ... F_Q$) of the cascade each receive a complex value input signal and deliver a complex value output signal and wherein the output filters of the cascade each receive a complex value input signal and deliver a real value output signal, characterised thereby, that a complex multiplier, by which either the complex value output signal of the filter of the preceding cascade stage or the input signal is multiplied by the complex sequence of a complex carrier oscillation scanned in such a manner, is inserted after the same cascade stage in each of the individual filter cascades and that the filters of the preceding cascade stages each consist of two separate identical low-pass filters with real co-efficients.

3. Filter bank according to claim 1 or 2, characterised thereby, that the factor M is resolved into two factors with a power $2^i$ of two as first factor and a second factor which is equal to $M/2^i$, wherein i is equal to a natural number.

4. Filter bank according to claim 3, characterised thereby, that the factor of the power $2^i$ of two is realised by a cascade of i filters each with $M_q = 2$.

**5.** Filter bank according to claim 4, characterised thereby, that the low-pass filter is a half-band filter.

**6.** Filter bank according to one of the preceding claims, characterised thereby, that the complex carrier oscillation conforms to the function $e^{-j2\pi k f_1^q / f_A^q}$, wherein k signifies the number of the scanning probe, $f_1^q$ the channel band centre frequency in the cascade stage q and $f_A^q$ the scanning frequency in the cascade stage q.

**Revendications**

**1.** Banc de filtres pour le multiplexage/le démultiplexage par répartition en fréquence des signaux de L canaux, avec L 0 et L, nombre naturel, constitué de L filtres transversaux (filtres non récursifs, filtres à longue durée finie de la réponse impulsionnelle (FIR)), à coefficients complexes pour signaux d'entrée réels et à signaux de sortie complexes, avec, à la sortie, une cadence d'échantillonnage réduite du facteur M, banc de filtres dans lequel au moins l'un des L filtres est réalisé par un montage en cascade d'au moins deux filtres à, chacun, coefficient complexes, dans lequel, à chaque filtre ($F_1$, ... $F_q$, ... $F_Q$) existant à l'intérieur de cette cascade, la cadence d'échantillonnage est réduite du facteur $M_q > 1$, avec

$$\prod_{q=1}^{Q} M_q = M,$$

dans lequel les filtres d'entrée ($F_1$) de la cascade reçoivent chacun un signal d'entrée réel et émettent un signal de sortie complexe et dans lequel les autres filtres de la cascade reçoivent chacun un signal d'entrée complexe et émettent un signal de sortie complexe, dans lequel, banc de filtre caractérisé par le fait que, dans chacune des différentes cascades de filtre, avant le même étage de la cascade, est inséré un multiplicateur complexe au moyen duquel on multiplie le signal de sortie complexe du filtre de l'étage précédent de la cascade (q-1) ou le signal d'entrée par la suite complexe d'une onde porteuse complexe, échantillonnée de façon telle que les filtres de l'étage suivant de la cascade (q) soient chacun constitués de deux filtres passe-bas distincts identiques, à coefficients réels.

**2.** Banc de filtres pour le multiplexage/le démultiplexage par répartition en fréquence des signaux de L canaux, avec L > 0 et L, nombre naturel, constitué de L filtres transversaux (filtres non récursifs, filtres à longue durée finie de la réponse impulsionnelle (FIR)), à coefficients complexes pour signaux d'entrée complexes et à signaux de sortie réels, avec, à la sortie, une cadence d'échantillonnage augmentéee du facteur M, banc de filtres dans lequel au moins l'un des L filtres est réalisé par un montage en cascade d'au moins deux filtres à, chacun, coefficients complexes, dans lequel, à chaque filtre ($F_1$, ... $F_q$, ... $F_Q$) existant à l'intérieur de cette cascade, la cadence d'échantillonnage est réduite du facteur $M_q > 1$, avec

$$\prod_{q=1}^{Q} M_q = M,$$

dans lequel les Q-1 premiers filtres ($F_1$, ... $F_q$, ... $F_{Q-1}$) de la cascade reçoivent chacun un signal d'entrée complexe et émettent un signal de sortie complexe et dans lequel les filtres de sortie de la cascade reçoivent chacun un signal d'entrée complexe et émettent un signal de sortie réel, banc de filtres caractérisé par le fait que, dans chacune des différentes cascades de filtre, après le même étage de la cascade, est inséré un multiplicateur au moyen duquel on multiplie le signal de sortie complexe du filtre de l'étage précédent de la cascade ou le signal d'entrée par la suite complexe d'une onde porteuse complexe, échantillonnée de façon telle que les filtres des étages précédents de la cascade soient chacun constitués de deux filtres passe-bas distincts, identiques, à coefficients réels.

**3.** Banc de filtres selon la revendication 1 ou 2, caractérisé par le fait que le facteur M se décompose en deux facteurs avec une puissance de deux $2^i$ comme premier facteur et un second facteur qui est égal à $M/2^i$, i étant égal à un nombre naturel.

**4.** Banc de filtres selon la revendication 3, caractérisé par le fait que le facteur puissance de deux $2^i$ est

réalisé par une cascade de i filtres ayant chacun comme facteur $M_q = 2$.

5. Banc de filtres selon la revenciation 4, caractérisé par la fait que le filtre passe-bas est un filtre demi-bande.

6. Banc de filtres selon l'une des revendications précédentes, caractérisé par le fait que l'onde porteuse complexe satisfait la fonction $e^{-j2\pi k f_l^q / f_A^q}$ k étant le numéro de l'épreuve d'échantillonnage, $f_l^q$ étant la fréquence centrale de la bande passante du canal dans l'étage d'ordre q de la cascade et $f_A^q$ étant la cadence d'échantillonnage dans l'étage d'ordre q de la cascade.

# FIG.1

l=1      ursprünglich $\underline{H}_l(z)$      = komplexwertige
Signale

FDM-Signal

l

(reell oder
komplexwertig)

l+u

$F_1$      $F_q$      $F_Q$

L

alle Blöcke:
Filter mit
komplexen
Koeffizienten

Alle Filter 1.Kask.-stufe mit untersch.Koeff.

Alle Filter 2.Kask.-stufe mit untersch. Koeff.

Alle Filter aller Kaskaden-stufen mit untersch. Koeff.

$f_A$      $f_A^I = \dfrac{f_A}{2}$      $f_A^{II} = \dfrac{f_A}{4}$      $f_A^{III} = \dfrac{f_A}{8}$

$\downarrow 2\underline{H}_{l1}$      $\downarrow 2\underline{H}_{l2}$      $\downarrow 2\underline{H}_{l3}$

# FIG.2

$F_1$      $F_q$      $F_Q$

alle Filter mit komplexen Koeffizienten

komplexe
Koeff.      reelle
Koeff.      reelle
Koeff.

$S_1$      $\underline{S}_2'$      $\underline{S}_2$      $\underline{S}_3$      $\underline{S}_4$

$\downarrow 2\underline{H}_{l1}$      $\downarrow 2\underline{H}_{l2}$      $\downarrow 2\underline{H}_{l3}$

$f_A$    $F_1$      $f_A^I$    $F_q$      $f_A^{II}$    $F_Q$      $f_A^{III}$

$e^{-i2\pi k f_l^I / f_A^I}$

# FIG.3a

FIG. 4

komplexe
Koeff.

komplexe
Koeff.

reelle
Koeff.

$\downarrow 2H_{l1}$

$\downarrow 2H_{l2}$

X

$\downarrow 2H_{l3}$

$\overline{e}\, j2\pi k\, f_A^{II}/f_A^{II}$

**FIG. 3b**

$F_1$

$F_q$

$F_Q$

$\cos 2\pi k\, f_l^q/f_A$

Re

X

+

Re

X

+

X

−

$\overline{e}\, j\, 2\pi k\, f_l^q/f_A^q$

X

+

Jm

+

Jm

**FIG. 5**

$-\sin 2\pi k\, f_l^q\, /f_A^q$

$\downarrow 2H_{lq}$

Re

$\downarrow 2H_{lq}$

Re

Jm

$\downarrow 2H_{lq}$

Jm

**FIG. 6**

$H_{lq}$: Halbbandfilter mit
reellen Koeffizienten

Re,(Jm)

$f_A = \dfrac{1}{T}$

2T  2T  2T

h(-3)  h(-1)  h(1)  h(3)

1

0

$f_A$

$\dfrac{n-3}{2}T$

h(0) (=1/2)

+ Re,(Jm')

## FIG. 7

$f_A$  $f_A^{I}$ Multipl.  $f_A^{II}$  $f_A^{III}$  $f_A^{IV}$  $f_A^{V}$  $f_A^{VI}$

1  X  2  3  4  5  6

$\mp_1$  $\mp_q$  $\mp_Q$

## FIG. 8